# EUROPEAN PATENT APPLICATION

(11) **EP 3 287 585 A1**
(43) Date of publication of application: **28.02.2018**
(21) Application number: 16185190.2
(22) Date of filing: 22.08.2016
(51) Int. Cl.: E05F 15/46, H03K 17/975, H03K 17/955

(54) **CAPACITIVE JAM PROTECTION**

(71) Applicant: Captron Electronic GmbH, 82140 Olching (DE)
(72) Inventor: HÜTTENHOFER, Kilian, 81476 München (DE); BELLM, Reinhard, 82110 Germering (DE)
(74) Representative: Lohr, Georg

(57) **Abstract**

Device for detecting the presence of an object close to or within an door opening defined by two door sections comprising at least one sensor at each door section. Each sensor comprising at least one reference conductor and at least one sensing line insulated and distant from the at least one reference conductor. The at least one sensing line being connected to an amplifier generating an output signal indicating the signal strength and/or attenuation of a signal at the at least one sensing line. A control circuit is provided, further comprising a signal generator and a switch unit having at least a first output and a second output, whereas in a first measurement mode A, the first output is connected to the signal generator and the second output is connected to ground, and in a second measurement mode B, the first output is connected to ground and the second output is connected to the signal generator. An evaluation unit is provided for correlating an output signal measured in mode A with an output signal measured in mode B.

## Description

### Field of the invention

The invention relates to a capacitive jam protection for doors, preferably for doors of vehicles.

### Description of the related art

Automatically closing doors in accessible areas, like doors in trains, busses, all kinds of vehicles, elevators, or windows, car roofs or similar require monitoring of the closure area for persons or body parts to avoid jamming.

The German Patent DE 102 20 725 C1 discloses a device for jamming detection. A rubber seal at a window frame includes an electrical conductor for detecting changes in the electrical field, which may be caused by persons or body parts which have a moderate conductivity, and therefore easily influence electrical fields. Furthermore, an electrical shield is provided to reduce effects of the window on the electrical field of the conductor. This solution cannot be used for dual doors operating in opposite directions, as in a position where both doors are close to each other the electrical field of a signal line in the first door directly influences a signal line in the second door, and therefore makes the device insensitive for small changes which may be induced by a human body or body parts in the proximity of the doors.

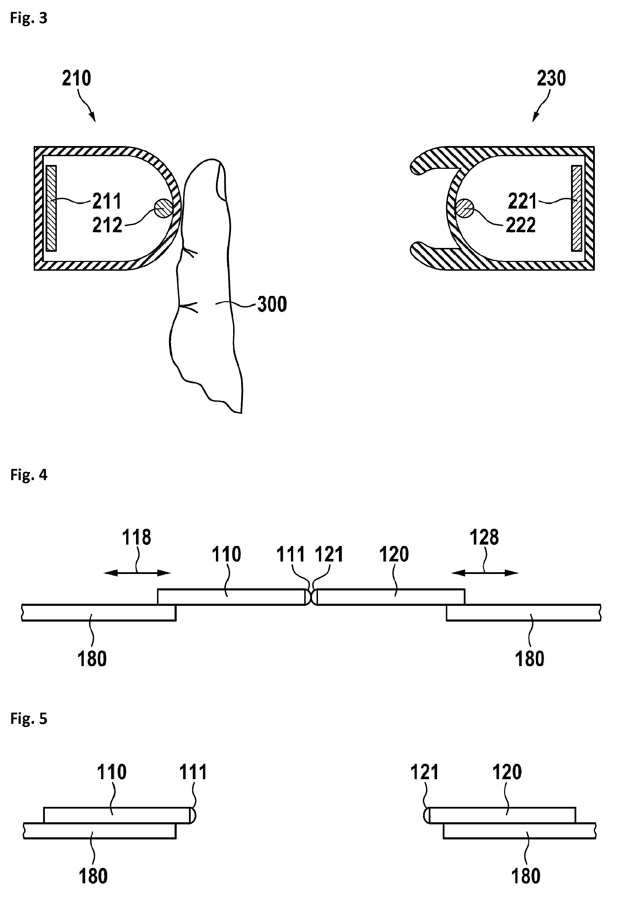

The German patent DE 10 2008 005783 B4 discloses a further capacitive jamming protection. Also here, a rubber seal includes a signal line together with a shield to reduce effects of the environment. When two opposing doors as shown in Figure 3 are used, the shields of the sealings are supplied with clock signals having a phase shift of 180 degrees. A sensing line in-between, integrated in one of the seals picks up the signals which are further amplified and rectified by a synchronous rectifier. The rectified signal is fed to a differential amplifier forming a control loop, and further controlling the amplitude of the clock signals, such that the sum signal at the sensing line equals to zero. When a body part approaches a sensing line, the control amplifier has to adapt the clock signals. Therefore, the control amplifier's output voltage is an indication of the object in the proximity of the sensing line. The problem arises, if both doors are close to each other. A small finger approaching one of the seals can hardly be detected, as the signal being coupled from the opposing door has a significantly larger effect than the small finger.

### Summary of the invention

The problem to be solved by the invention is to provide a capacitive jamming detection which may be used for dual section doors and which may be based on standard door sealing having one signal conductor and a shield, while achieving a higher sensitivity. Solutions of the problem are described in the independent claims. The dependent claims relate to further improvements of the invention.

A first embodiment is based on the first sensor in the first door section and a second sensor and a second door section. When closing the door the first door section approaches the second door section and consequently the first sensor approaches the second sensor. Preferably, both doors sections are movable, but also the first section may be movable, whereas the second section the stationary or vice versa. In a closed state of the door, the sensors are close to each other, whereas in an open state of the door, they are distant from each other. Preferably, at least one the sensor is integrated into or at least connected to a door sealing, which may further provide a mechanical protection. It is further preferred, if the sensors comprise a soft and/or flexible sensor housing which may prevent damage of an object preferably having a certain conductivity or a person between the door sections when the door is closing or closed. In an alternate embodiment, the housing may be any material suitable for holding the components, preferably an insultiung material. Preferably, the sensors cover an edge and/or a narrow side of at least one door section. There may be a single sensor covering the whole action and/or a narrow side of the door section. Such a sensor may have a length between two and 2.5 m. Alternatively, there may be a plurality of shorter sensor sections, for example having a length between .3 and 1 m. Each sensor preferably comprises at least one reference conductor and at least one sensing line insulated and distant from the reference conductor. Preferably, the at least one reference conductor and the at least one sensing line are integrated into a common housing which preferably comprises a soft of flexible material like rubber or any other suitable polymer.

For detecting an object in between or in close proximity to the sensors and or the door section, at least two different measurements have to be made which are further designated as measurement mode A and measurement mode B. In a first measurement mode A, a measurement signal is applied to the reference conductor of the first sensor, while the reference conductor of the second sensor is grounded. In the second measurement mode B, the reference conductor of the first sensor is grounded, while the measurement signal is applied to the reference conductor of the second sensor. Switching between the measurement modes may be done by a switch unit which selects a connection between a sensor reference conductor and a signal generator providing the measurement signal or ground according to the selected measurement mode. The measurement signal may be an AC signal having a frequency between 10 kHz and 10 MHz and a signal amplitude between 100 mV and 20 V. In both modes, the signal of a sensing line in the first sensor is evaluated.

In mode A, part of the measurement signal applied to the reference conductor of the first sensor is coupled capacitive to the sensing line of the first sensor. There may be a further capacitive bypass by a an object close to the sensing line and/or the second sensor which may be close to the first sensor in a door closed state or distant from the first sensor in an door open state. Such capacitive bypasses further attenuate the signal at the sensing line.

In mode B, part of the measurement signal applied to the reference conductor of the second sensor is coupled capacitive to the sensing line of the first sensor. There may be a further capacitive bypass by a an object close to the sensing line and/or the first sensor which may be close to the second sensor in a door closed state or distant from the second sensor in an door open state. Such capacitive bypasses further attenuate the signal at the sensing line. Due to the large capacitance of the grounded reference conductor of the first sensor, an object close to the first sensor has a negligible effect.

Generally, the environment, like the doors, walls, holding the doors, or a floor are referenced to ground. In a vehicle like a bus, these components almost comprise metal and therefore provide a good ground which also may provide an attenuation on the measurement signal. In the case of metal doors or significant metal components within the doors, which are preferably electrically connected to ground, the measurements may also work, even if the reference conductor, into which no measurement signal is coupled, is not grounded. Furthermore, a person standing on a grounded floor or being close to a grounded door has sufficient capacitive coupling to ground to provide attenuation on the signal line when approaching a sensor.

To generate a signal indicating the presence of an object in proximity to the first sensor, the attenuations measured in mode A is correlated with the attenuations measured in mode B. This may for example be made by marking the attenuations in a two-dimensional diagram, for example, each measurement forming a point with mode B along the X axis and mode A along the Y axis. When no object is in proximity of the first sensor, the points of attenuation are on a first curve or fall into a certain area. When there is an object in close proximity to the first sensor, the points of correlation are on a second curve or area, distant from the first curve or area. Approximately, the distance of the curves varies with the distance of the object is to the first sensor line. This kind of correlation and/or evaluation may be done in an evaluation unit, which may be a microcontroller. An object presents signal may be generated if the correlated signals for into a predetermined area.

In this example, the measurement of mode B may also be used to estimate the distance between sensors and therefore between the door sections.

If the distance of an object with respect to the second sensor should be measured, application of a measurement signal and the sensing line is interchanged between the first and the second sensor.

In another embodiment, there may ba a further mode C, where both reference conductors are fed by the same signal. This mode may be used supplementary to and/or replacing Mode A.

In a further embodiment, there may be at least a further line approximately in parallel to a sensing line, most preferably in parallel to the first sensing line. The second line may be connected to the reference conductor of the same sensor and therefore perform a certain degree of shielding. If, for example there are two parallel lines at the top of the sensor, a first line may be used as a sensing line, whereas the second one may be connected to the reference conductor. Such incentives comparatively sensitive to approaching an object from the side of the sensing line, whereas it is insensitive to an approaching object from the side of the line used for shielding. There may also be a plurality of lines used for shielding to achieve complex sensitivity patterns.

Preferably, there are two identical sensors at the door section. This allows the same degree of object detection and protection at and of each of the door section. In a simplified embodiment, they may be a sensing line only at the first sensor. A sensing line at the second sensor is not necessary, if it is not desired to detect objects close to the second sensor.

In a further embodiment, approaching of an object in a closed state of the door may be detected as mentioned above. This may be used to generate a signal, for example to request opening of the door. Therefore, there is a second function of the device described above replacing a door opening request switch. Of course this sensor may trigger any other function.

A further embodiment relates to a method of operating a sensor and a method of detecting the presence of an object as disclosed above.

### Description of Drawings

In the following the invention will be described by way of example, without limitation of the general inventive concept, on examples of embodiment with reference to the drawings.
Figure 1 shows a first embodiment.
Figure 2 shows another embodiment.
Figure 3 shows a further embodiment of sensors.
Figure 4 shows a common sliding door in a closed state.
Figure 5 shows the sliding door in an open state.
Figure 6 shows signals measured by the control circuit.
Figure 7 shows a position-independent signal.

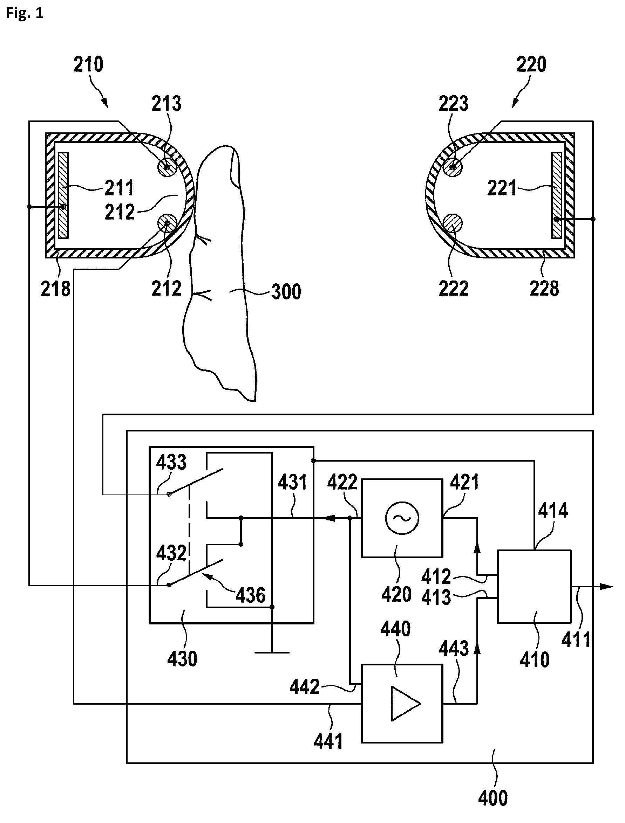

In Figure 1, a first embodiment is shown. A first sensor 210, second sensor 220, and a control circuit 400 are provided for detecting an object 300, like a finger or any other body part of a person. Preferably, the sensors are at the inner sides of a door, preferably of a sliding door, and most preferably of an automatic sliding door.

Each sensor preferably comprises a reference conductor 211, 221, at least one sensing line 212, 213, 222, 223, and housing 218, 228. Preferably, the housing comprises a soft or flexible material like rubber or any other suitable polymer. The housing basically has two functions. The first function is to hold the sensing lines in a predetermined position with respect to the reference conductors. The second function is a mechanical function, such that the housing is compressed under high pressure, and therefore prevents damage of an object or a person between the door sections when the door is closing or closed.

The embodiment shown in this figure is for detecting an object 300 in close proximity to the first sensor 210. If an object in close proximity of the second sensor 220 has to be detected, the order of sensors may simply be reversed or exchanged, preferably in certain and/or predetermined measurement intervals. Therefore, the first sensor has the function of the second sensor and vice versa. This does not require changing the circuit. Instead, this may be done for example, by software, within the control circuit 400. The control circuit 400 preferably comprises a signal generator 420 (which is preferably reference to ground) to produce an output signal for driving at least one of the reference conductors and or of the sensing lines. Basically, there are two measurements modes, as will be explained later in more detail. In a first measurement mode A, a measurement signal is applied to the first sensor reference conductor, while the second sensor reference conductor is grounded. In the second measurement mode B, the first reference conductor is grounded, while the measurement signal is applied to the second reference conductor. Switching between the measurement modes is done by a switch unit 430 which selects a connection between a sensor reference conductor and a signal generator or ground according to the selected measurement mode.

The switch unit 430 preferably has at least two switches 436 which preferably are operated synchronously. The switches may be relays or solid-state switches. Preferably, there is a switch input which may be connected to a generator output 422 to receive a generator's signal. Furthermore, there are at least two outputs 432, 433 which may be connected to the sensors. Preferably the outputs are toggled between ground and the generator's signal. Therefore, for example for selecting mode A, the first switch output 432 is connected to the generator's signal, whereas the second switch output 433 is connected to ground. For selecting mode B, the connections of the outputs are reversed.

In this embodiment, the second sensing line 213 of the first sensor is connected in parallel with the first sensor reference conductor 211. This results in a certain direction sensitivity. The resulting sensitivity for detecting an object close to the first sensing line 212 is much higher than close to the second sensing line 213. Therefore, as shown in this Figure, a finger 300 approaching from the bottom side may be detected from a larger distance, whereas a finger being approached from the top side would hardly be detected. This allows a certain selectivity, for example in a bus where it may be desired only to detect an object approaching the door from the inside, but not from the outside of the bus or vice versa.

The signal which is fed into the reference conductors is capacitive coupled via the air gap between the reference conductors and a sensing line into the sensing lines. The signal is fed through signal input 441 from the outside into an amplifier 440 which may have a rectifier or preferably a synchronous rectifier which may be controlled by a signal received at a sync input 442 generated by the signal generator 420. The amplifier may further comprise certain high pass or low pass filters to select a desired signal. The signal at the output 443 of the amplifier 440 is fed via input 413 to an evaluation unit which may be a microcontroller 410, which controls at least parts of the control circuit 400. The microcontroller may further trigger or control via switch control line 414 the switch 430 and may further feed via generator control line 412 a control signal to the signal generator 420 via control input 412. It may further provide an output signal at output line 411 at least indicating whether an object is present or not. As will be shown later, the control circuit may even provide an indication about the distance of the object and/or the distance between the door sections.

For selecting the direction of main sensitivity, as described above, one of the sensing lines 212, 213 may be connected to the reference conductor 211. Alternatively, none of the sensing lines may be connected to the reference conductor, but both may be used to feed the amplifier 440. In a closed state of the door, where first sensor 210 and second sensor 220 are close to each other, objects close to the sensors may be detected.

Further, by evaluating the different signals from the different sensing lines and/or connecting at least one sensing line to a sensor reference conductor, it is also possible to detect from which side an object has approached the door. This may for example be used as a request switch for a person approaching a vehicle from the outside for opening the door. Therefore, an additional switch is no more necessary. As explained above, this switch may only be sensitive to an object approaching from the outside, but not from the inside. This may avoid erroneous triggering of the door open request signal. If, for example in the embodiment shown in this figure, the top side of the figure would be an inside of a vehicle and the bottom side would be an outside thereof, the sensors would be more sensitive to an object 300 (e.g. a finger) approaching from the bottom of the figure (outside) compared to an object approaching from the top of the figure (inside). This allows clearly distinguishing the approach side and therefore may be used as a switch for signaling for example a door open request.

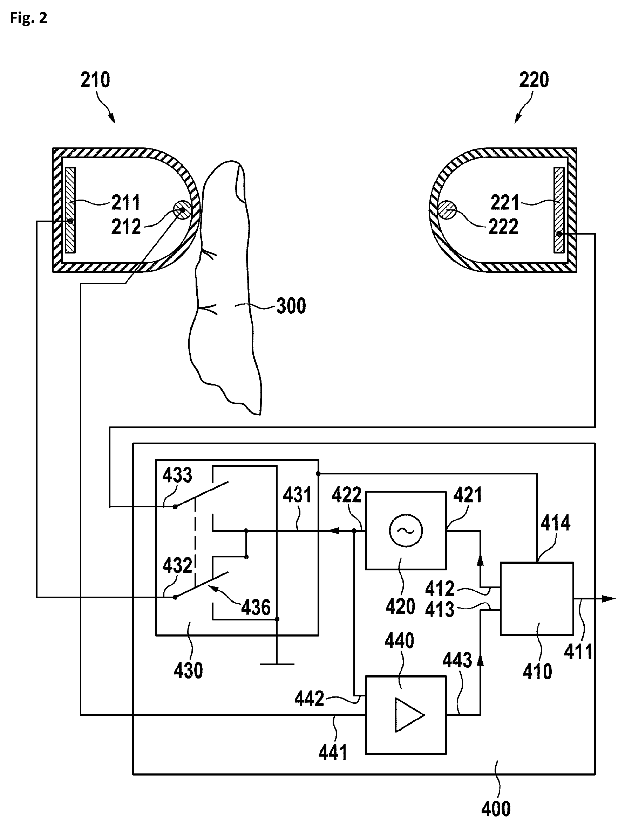

In Figure 2, a previous embodiment is shown. Here, the sensors comprise only a single sensing line, which simplifies the circuit but does not provide further selectivity of the object approaching from inside or outside of the door.

In Figure 3, a further embodiment of sensors is shown. Whereas the first sensor 210 is the same as previously described, the second sensor 230 may have a different shape, which allows a better sealing of the door, when the first sensor mates with the second sensor in a closed state of the door.

In Figure 4, a common sliding door in a closed state is shown in a top view, which may be used in buses or trains or other public transportation vehicles, or in elevators or buildings. This door may be a planar sliding door or a rotating door. A wall 180 may have an opening which may be closed by a door. There is a first sliding door section 110 which is movable into a first direction 118 of movement, and a second sliding door section 120 being movable in a second direction 128 opposing the first direction 118. Between the sliding doors at the inside of the opening are a first sensor 111 and a second sensor 121, as described above.

In Figure 5, the previous sliding door is shown in an open state.

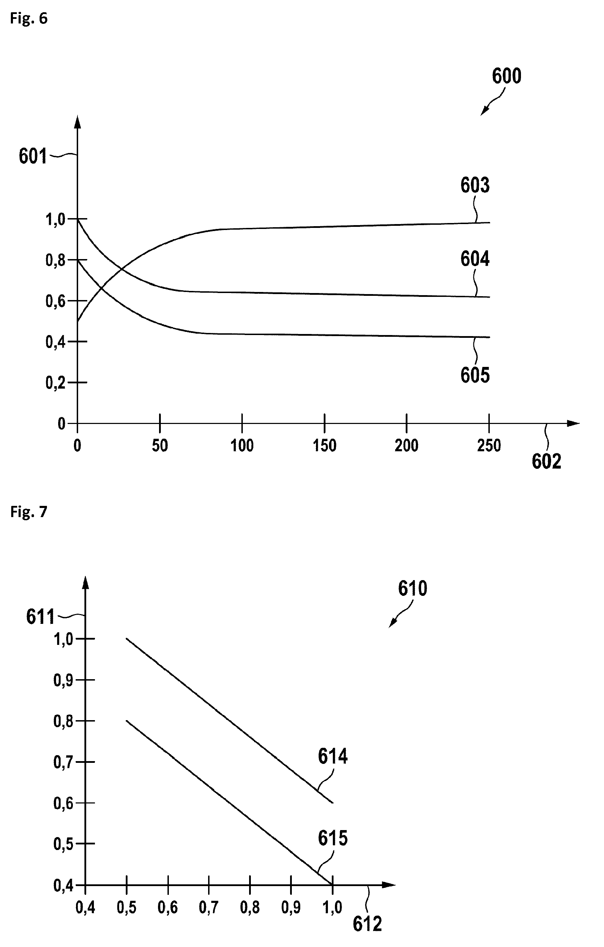

In Figure 6, signals as measured by the control circuit 400 are shown. A diagram 600 provides an x-axis 602 which shows an opening distance between two sections of a door, the scale may be calibrated in millimeters, whereas a y-axis 601 shows the relative signal attenuation. A value of 1 means a maximum attenuation, whereas 0 is no attenuation. In general, there is a certain attenuation due to the capacitive coupling between a reference conductor and a sensing line, such that a signal never would reach the 0 attenuation value. The first curve 603 shows the attenuation of a signal in mode B, where the reference conductor of the second sensor 220 as shown in Figure 1 is fed by a signal, while the reference conductor of the first sensor 210 is grounded. At a 0 distance, with the door closed, a signal is coupled from the reference conductor of the second sensor into the sensing line of the first sensor which a comparatively low attenuation of about 50 % in this example. When the door opens, the distance between the first sensor and the second sensor increases, and therefore the capacitive coupling gets weaker, and the attenuation increases.

The curves 604 and 605 show the attenuation in mode A, whereas curve 604 shows the state with an object like a finger being in close proximity to the sensing line of the first sensor, and the second curve 605 shows the attenuation without any object. In mode A, the reference conductor of the first sensor 210 as shown in Figure 1 is fed by a signal, while the reference conductor of the second sensor 220 is grounded When the door is closed, there is a comparatively high attenuation of the signal fed into the reference conductor of the first sensor 210, due to the grounded reference conductor of the second sensor 220 in a close distance. When the door opens, the coupling to the grounded reference conductor of the second sensor decreases, and therefore the attenuation of the signal further decreases. When an object is in close proximity to the sensing line of the first sensor, this further increases attenuation as shown in curve 604.

This diagram shows the difficulties in evaluating whether an object is in close proximity to the first sensor or not, at different openings of the door. For example, in a closed state of the door, the attenuation without any object (curve 605) is higher than the attenuation with an opening of 100 mm with an object (curve 604). Therefore, the approaching doors supersede the effect of an object like a person or a body part significantly.

In Figure 7, a position-independent signal is shown. Diagram 610 shows at its x-axis the attenuation of mode B, and at its y-axis the attenuation of mode A. For each point of curve 604 and 605 (mode B), the corresponding points measured at the same distance of door opening according to curve 603 (mode A) are entered into the diagram. The combination of curves 604 and 603 results in a curve 614, whereas curves 605 and 603 result in curve 615. As a result, there are two curves which are independent of the opening of the door. These curves are approximately linear or may at least be approximated by a linear curve. There is a significant measurement effect which allows easy distinguishing between the curves, and therefore concluding whether an object is close or not. Such an evaluation may be done by the microcontroller 410.

A further benefit is the measurement of mode B, which allows a rough estimate of the door opening distance, at least for small openings independent of if an object is in-between the door sections or not.

### List of reference numerals

- 110: first sliding door section
- 111: first sensor
- 118: first direction of movement
- 120: second sliding door section
- 121: second sensor
- 128: second direction of movement
- 180: wall
- 210: first sensor
- 211: sensor reference conductor
- 212: first sensing line
- 213: second sensing line
- 218: sensor housing
- 220: second sensor
- 221: sensor reference conductor
- 222: first sensing line
- 223: second sensing line
- 228: sensor housing
- 300: object
- 400: control circuit
- 410: microcontroller
- 412: generator control line
- 413: input
- 414: switch control line
- 420: signal generator
- 422: generator output
- 430: switch unit
- 431: switch input
- 432: first switch output
- 433: second switch output
- 436: switches
- 440: amplifier
- 441: signal input
- 442: sync input
- 443: amplifier output
- 480: wall
- 600: diagram
- 601: y-axis
- 602: x-axis
- 603: curve showing attenuation in mode B
- 604, 605: curve showing attenuation in mode A
- 614: combination of curves 604 and 603
- 615: combination of curves 605 and 603

## Claims

1. Device for detecting the presence of an object close to or within an door opening defined by two door sections (110, 120) comprising at least one sensor (210, 220) at each door section, each sensor comprising at least one reference conductor (211, 221) and at least one sensing line (212, 222) insulated and distant from the at least one reference conductor, the at least one sensing line being connected to an amplifier (440) generating an output signal indicating the signal strength and/or attenuation of a signal at the at least one sensing line,
**characterized in, that**
a control circuit (400) is provided, the control circuit further comprising a signal generator (420) and a switch unit (430) having at least a first output (432) and a second output (433), whereas in a first measurement mode A, the first output is connected to the signal generator and the second output is connected to ground, and in a second measurement mode B, the first output is connected to ground and the second output is connected to the signal generator.

2. Device according to claim 1,
**characterized in, that**
an evaluation unit (410) is provided for correlating an output signal (604, 605) measured in mode A with an output signal (603) measured in mode B.

3. Device according to claim 2,
**characterized in, that**
the evaluation unit (410) generates an object present signal (411) if the correlated signals fall into a predetermined area.

4. Device according to claim 3,
**characterized in, that**
the object present signal is used as a door opening request signal.

5. Device according to any of the previous claims,
**characterized in, that**
at least one sensor comprises a soft and/or flexible housing.

6. Device according to any of the previous claims,
**characterized in, that**
at least one sensor comprises at least one further line, which may be connected to the reference conductor.

7. Device according to any of the previous claims,
**characterized in, that**
an evaluation unit (410) is provided for calculating a door opening distance estimate from the output signal (603) measured in mode B.

8. Device according to any of the previous claims,
**characterized in, that**
the order of the first sensor and the second sensor is exchanged.

9. Device according to any of the previous claims,
**characterized in, that**
the order of the first sensor and the second sensor is exchanged in certain measurement intervals.

10. Method for operating a first sensor and a second sensor, each sensor comprising at least one reference conductor (211, 221) and at least one sensing line (212, 222) insulated and distant from the at least one reference conductor, by in a first measurement mode A, feeding an AC signal into the reference conductor of the first sensor and measuring signal strength and/or attenuation of a signal at the at least one sensing line of the first sensor and in a second measurement mode B, feeding an AC signal into the reference conductor of the second sensor and measuring signal strength and/or attenuation of a signal at the at least one sensing line of the first sensor.

11. Method of detecting the presence of an object close to a sensor operated according to claim 10, by further correlating an output signal (604, 605) measured in mode A with an output signal (603) measured in mode B.
